# EUROPEAN PATENT APPLICATION

(11) **EP 4 845 181 A1**
(43) Date of publication of application: **25.11.2026**
(21) Application number: 24926174.4
(22) Date of filing: 31.12.2024
(51) Int. Cl.: H04R 3/04, H03H 7/01, H04R 5/04

(54) **ELECTRONIC DEVICE AND CONTROLLING METHOD FOR SAME**

(30) Priority: 22.02.2024 KR 20240026104
(71) Applicant: Samsung Electronics Co., Ltd., Suwon-si, Gyeonggi-do 16677 (KR)
(72) Inventor: KIM, Dongwoo, Suwon-si Gyeonggi-do 16677 (KR); KIM, Dowon, Suwon-si Gyeonggi-do 16677 (KR); LEE, Yoonjae, Suwon-si Gyeonggi-do 16677 (KR); KIM, Sunmin, Suwon-si Gyeonggi-do 16677 (KR); KIM, Hanki, Suwon-si Gyeonggi-do 16677 (KR)
(74) Representative: Appleyard Lees IP LLP
(86) International application number: PCT/KR2024/021569
(87) International publication number: WO 2025/178228

(57) **Abstract**

This electronic device comprises a speaker, a microphone and a processor, wherein the processor can acquire a low frequency band ratio of a playback audio signal output through the speaker and a low frequency band ratio of a microphone audio signal received through the microphone, and process the playback audio signal on the basis of the low frequency band ratio of the playback audio signal and the low frequency band ratio of the microphone audio signal.

## Description

### Technical Field

The present disclosure relates to an electronic device for outputting audio and a control method thereof.

### Background Art

Electronic devices that output audio may be, depending on their installation locations or playback spaces, subjected to sound quality degradation by which the quality of audio signals such as sound or music becomes worse than the original quality.

Excessive low frequency bands resulting from such sound quality degradation may seriously degrade the quality of playback audio. Accordingly, the low frequency bands need to be corrected and such correction is important for reproducing distortion-free sound.

In the related art, an electronic device has corrected low frequency bands by generating impulse noise for a certain period of time, obtaining an impulsive response (IR) for an installation location of the electronic device through a microphone in the electronic device, converting the IR into a frequency response (FR), and then correcting the FR to match with a standard FR.

The related art method requires long time and a large amount of computation to obtain the FR. In the case of the electronic device being a portable electronic device, the process is repeated whenever the position of the portable electronic device changes, which requires longer time and more computation to obtain the FR. In addition, in the case where there is no or insufficient sound source in a specific frequency band, the accuracy of the FR is very low. In this case, incorrect correction may actually worsen the sound quality.

### Disclosure

### Technical Problem

One aspect of the present disclosure provides an electronic device and a control method thereof, capable of providing high-quality sound by quickly and simply correcting a low frequency band regardless of a space where the electronic device is installed.

### Technical Solution

An electronic device according to an aspect of the present disclosure may include: a speaker; a microphone; and a processor configured to obtain a low frequency band ratio of a playback audio signal output through the speaker and a low frequency band ratio of a microphone audio signal received through the microphone, and process the playback audio signal based on the low frequency band ratio of the playback audio signal and the low frequency band ratio of the microphone audio signal.

A control method of an electronic device according to an aspect of the present disclosure may include: obtaining a low frequency band ratio of a playback audio signal output through a speaker; obtaining a low frequency band ratio of a microphone audio signal received through a microphone; and processing the playback audio signal based on the low frequency band ratio of the playback audio signal and the low frequency band ratio of the microphone audio signal.

A non-transitory storage medium according to an aspect of the present disclosure, storing instructions readable by a computer, may cause, when the instructions are executed by a processor, the processor to obtain a low frequency band ratio of a playback audio signal output through a speaker; obtain a low frequency band ratio of a microphone audio signal received through a microphone; and process the playback audio signal based on the low frequency band ratio of the playback audio signal and the low frequency band ratio of the microphone audio signal.

### Description of Drawings

FIG. 1 shows a network system implemented by various electronic devices.
FIG. 2 shows a control block diagram of an audio device according to an embodiment of the present disclosure.
FIG. 3 shows a control block diagram of a processor of an audio device according to an embodiment of the present disclosure.
FIG. 4 shows operations of a processor of an audio device according to an embodiment of the present disclosure.
FIG. 5 shows an example of a flowchart illustrating a control method of an audio device according to an embodiment of the present disclosure.
FIG. 6 shows examples of root mean square (RMS) values for frequency bands of a playback audio signal in an audio device according to an embodiment of the present disclosure.
FIG. 7 shows examples of RMS values for frequency bands of a microphone audio signal in an audio device according to an embodiment of the present disclosure.
FIG. 8 shows other examples of RMS values for frequency bands of a playback audio signal in an audio device according to an embodiment of the present disclosure.
FIG. 9 shows other examples of RMS values for frequency bands of a microphone audio signal in an audio device according to an embodiment of the present disclosure.

### Modes of the Invention

Various embodiments of the disclosure and terms used herein are not intended to limit the technical features described herein to specific embodiments, and should be understood to include various modifications, equivalents, or substitutions of the corresponding embodiments.

In describing of the drawings, similar reference numerals may be used for similar or related elements.

The singular form of a noun corresponding to an item may include one or more of the items unless clearly indicated otherwise in a related context.

In the disclosure, phrases, such as "A or B", "at least one of A and B", "at least one of A or B", "A, B or C", "at least one of A, B and C", and "at least one of A, B, or C" may include any one or all possible combinations of the items listed together in the corresponding phrase among the phrases.

As used herein, the term "and/or" includes any and all combinations of one or more of the associated listed items.

Terms such as "1st", "2nd", "primary", or "secondary" may be used simply to distinguish an element from other elements, without limiting the element in other aspects (e.g., importance or order).

When an element (e.g., a first element) is referred to as being "(functionally or communicatively) coupled" or "connected" to another element (e.g., a second element), the first element may be connected to the second element, directly (e.g., wired), wirelessly, or through a third element.

It will be understood that when the terms "includes", "comprises", "including", and/or "comprising" are used in the disclosure, they specify the presence of the specified features, figures, steps, operations, components, members, or combinations thereof, but do not preclude the presence or addition of one or more other features, figures, steps, operations, components, members, or combinations thereof.

When a given element is referred to as being "connected to", "coupled to", "supported by" or "in contact with" another element, it is to be understood that it may be directly or indirectly connected to, coupled to, supported by, or in contact with the other element. When a given element is indirectly connected to, coupled to, supported by, or in contact with another element, it is to be understood that it may be connected to, coupled to, supported by, or in contact with the other element through a third element.

It will also be understood that when an element is referred to as being "on" another element, it may be directly on the other element or intervening elements may also be present.

Hereinafter, an electronic device according to various embodiments of the disclosure will be described with reference to the accompanying drawings.

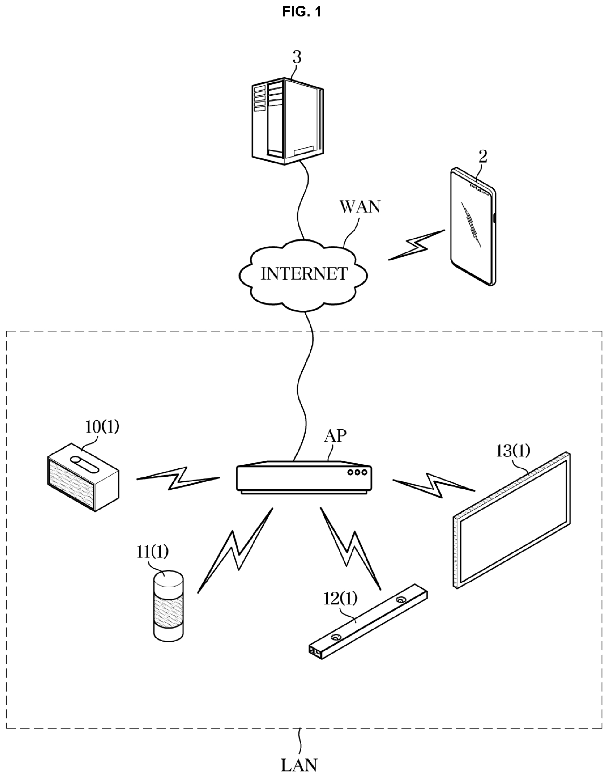

FIG. 1 shows a network system implemented by various electronic devices.

Referring to FIG. 1, an audio device 1 may include a communication module capable of communicating with another audio device, a user device 2, or a server 3, a user interface that receives a user input or outputs information to a user, at least one processor that controls an operation of the audio device 1, and at least one memory that stores a program for controlling the operation of the audio device 1.

The audio device 1 may be at least one of various types of audio devices. For example, as shown in the accompanying drawings, the audio device 1 may include at least one of a wi-fi speaker 10, a Bluetooth speaker 11, a sound bar 12, or a sound frame 13, but is not limited thereto. For example, the audio device 1 may include various types of appliances not shown in the drawings, such as a cleaning robot, a vacuum cleaner, a television, and the like. Furthermore, the aforementioned audio devices and home appliances are by way of example only, and in addition to the aforementioned audio devices and home appliances, appliances connected to other audio device, the user device 2, or the server 3 to perform operations described below may be included in the audio device 1 according to an embodiment.

The server 3 may include a communication module communicating with another server, the audio device 1, or the user device 2, at least one processor that processes data received from another server, the audio device 1, or the user device 2, and at least one memory that stores programs for processing data or processed data. The server 3 may be implemented as a variety of computing devices, such as a workstation, a cloud, a data drive, a data station, and the like. The server 3 may be implemented as one or more server physically or logically separated based on a function, detailed configuration of function, or data, and may transmit and receive data through communication between servers and process the transmitted and received data.

The server 3 may perform functions, such as managing a user account, registering the audio device 1 in association with the user account, managing or controlling the registered audio device 1, and the like. For example, a user may access the server 3 via the user device 2 and may create a user account. The user account may be identified by an identifier (ID) and a password set by the user. The server 3 may register the audio device 1 with the user account according to a predetermined procedure. For example, the server 3 may link identification information of the audio device 1 (e.g., a serial number or MAC address) to the user account to register, manage, and control the audio device 1. The user device 2 may include a communication module capable of communicating with the audio device 1 or the server 3, a user interface that receives a user input or outputs information to a user, at least one processor that controls an operation of the user device 2, and at least one memory that stores a program for controlling the operation of the user device 2.

The user device 2 may be carried by a user, or placed in a user's home or office, or the like. The user device 2 may include a personal computer (PC), a terminal, a portable telephone, a smartphone, a handheld device, a wearable device, and the like, but is not limited thereto.

The memory of the user device 2 may store a program for controlling the audio device 1, i.e. an application. The application may be sold installed on the user device 2, or may be downloaded from an external server for installation.

By running the application installed on the user device 2 by a user, the user may access the server 3, create a user account, and communicate with the server 3 based on the login user account to register the audio device 1.

For example, by operating the audio device 1 to allow the audio device 1 to access the server 3 according to a procedure guided by the application installed on the user device 2, the server 3 may register the audio device 1 with the user account by assigning the identification information (e.g., a serial number or a MAC address) of the audio device 1 to the corresponding user account.

A user may control the audio device 1 using the application installed on the user device 2. For example, by logging into a user account with the application installed on the user device 2, the audio device 1 registered in the user account appears, and by inputting a control command for the audio device 1, the control command may be delivered to the audio device 1 via the server 3.

A network may include both a wired network and a wireless network. The wired network may include a cable network or a telephone network, and the wireless network may include any networks transmitting and receiving a signal via radio waves. The wired network and the wireless network may be interconnected.

The network may include a wide area network (WAN), such as the Internet, a local area network (LAN) formed around an access point (AP), and a short-range wireless network that does not use an AP. The short-range wireless network may include Bluetooth (IEEE 802.15.1), Zigbee (IEEE 802.15.4), Wi-Fi Direct, near field communication (NFC), and Z-Wave, but is not limited thereto.

The AP may connect the audio device 1 or the user device 2 to a WAN connected to the server 3. The audio device 1 or the user device 2 may be connected to the server 3 via a WAN.

The AP may communicate with the audio device 1 or the user device 2 using wireless communication, such as Wi-Fi (IEEE 802.11), Bluetooth (IEEE 802.15.1), Zigbee (IEEE 802.15.4), and the like, and access a WAN using wired communication, but is not limited thereto.

According to various embodiments, the audio device 1 may be directly connected to the user device 2 or the server 3 without going through an AP.

The audio device 1 may be connected to the user device 2 or the server 3 via a long-range wireless network or a short-range wireless network.

For example, the audio device 1 may be connected to the user device 2 via a short-range wireless network (e.g., Wi-Fi Direct).

In another example, the audio device 1 may be connected to the user device 2 or the server 3 via a WAN using a long-range wireless network (e.g., a cellular communication module).

In still another example, the audio device 1 may access a WAN using wired communication, and may be connected to the user device 2 or the server 3 via a WAN.

When accessing a WAN using wired communication, the audio device 1 may also act as an AP. Accordingly, the audio device 1 may connect another audio device to a WAN to which the server 3 is connected. In addition, another audio device may connect the audio device 1 to the WAN to which the server 3 is connected.

The audio device 1 may transmit information about an operation or state to other audio devices, the user device 2, or the server 3 via the network. For example, the audio device 1 may transmit information about an operation or state to other audio devices, the user device 2 or the server 3 upon receiving a request from the server 3, in response to an event in the audio device 1, or periodically or in real time. Upon receiving the information about the operation or state from the audio device 1, the server 3 may update the stored information about the operation or state of the audio device 1 and transmit the updated information about the operation and state of the audio device 1 to the user device 2 via the network. Here, updating the information may include various operations in which existing information is changed, such as adding new information to the existing information, replacing the existing information with new information, and the like.

The audio device 1 may obtain various information from other audio devices, the user device 2, or the server 3, and may provide the obtained information to a user. For example, the audio device 1 may obtain information related to a function of the audio device 1 (e.g., information about currently playing audio, etc.) from the server 3 and various environmental information (e.g., weather, temperature, humidity, etc.), and may output the obtained information via a user interface.

The audio device 1 may operate in accordance with a control command received from other audio devices, the user device 2, or the server 3. For example, the audio device 1 may operate in accordance with a control command received from the server 3, based on a prior authorization obtained from a user to operate in accordance with the control command of the server 3 even without a user input. Here, the control command received from the server 3 may include a control command input by the user via the user device 2 or a control command based on preset conditions, but is not limited thereto.

The user device 2 may transmit information about a user to the audio device 1 or the server 3 via the communication module. For example, the user device 2 may transmit information about a user's location, a user's health condition (i.e., state), a user's preference, a user's schedule, and the like to the server 3. The user device 2 may transmit information about the user to the server 3 based on the user's prior authorization.

The audio device 1, the user device 2, or the server 3 may use techniques, such as artificial intelligence (AI) to determine a control command. For example, the server 3 may receive information about an operation or a state of the audio device 1 or information about a user of the user device 2, process the received information using techniques, such as AI, and transmit a processing result or a control command to the audio device 1 or the user device 2 based on the processing result.

The electronic device 1 described below may correspond to the aforementioned audio device 1. However, the electronic device 1 is not limited to the aforementioned audio device 1 and may include various types of devices such as audio systems.

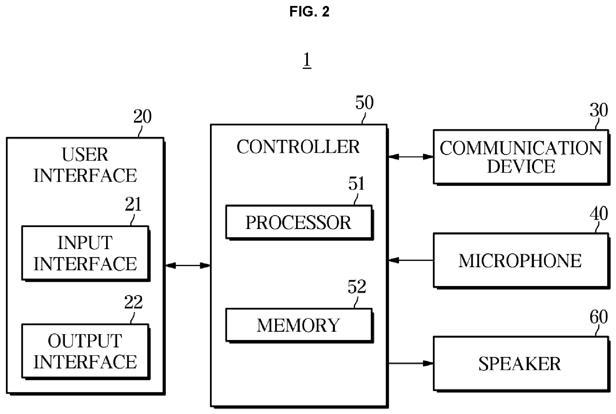

FIG. 2 shows a control block diagram of an audio device according to an embodiment of the present disclosure.

Referring to FIG. 2, an audio device 1 may include a user interface 20, a communication device 30, a microphone 40, a controller 50, and a speaker 60.

The user interface 20 may include at least one input interface 21 and at least one output interface 22.

The at least one input interface 21 may convert sensory information received from a user into an electrical signal.

The at least one input interface 21 may include a power button, an operation button, a menu selection button, a setting button, etc. The at least one input interface 21 may include, for example, a tact switch, a push switch, a slide switch, a toggle switch, a micro switch, a touch switch, a touch pad, a touch screen, and/or a jog dial, etc.

The at least one output interface 22 may visually or audibly convey information regarding operations of the audio device 1 to the user.

For example, the at least one output interface 22 may transmit information regarding an operation of the audio device 1 to the user. The information regarding the operation of the audio device 1 may be output through a screen, an indicator, a voice, etc. The at least one output interface 22 may include, for example, a Liquid Crystal Display (LCD) panel, a Light Emitting Diode (LED) panel, etc.

The communication device 30 may include at least one communication module. The communication module may establish a direct (for example, wired) communication channel or a wireless communication channel with the external device, and support communication through the established communication channel. According to an embodiment, the communication module may include a wireless communication module (for example, a cellular communication module, a short-range wireless communication module, or a global navigation satellite system (GNSS) communication module) or a wired communication module (for example, a local area network (LAN) communication module or a power line communication module). A corresponding communication module among the communication modules may communicate with an external device through a first network (for example, a short-range communication network, such as Bluetooth, WiFi Direct, or Infrared data association (IrDA)) or a second network (for example, a long-distance communication network, such as a legacy cellular network, a 5-Generation (5G) network, a next-generation communication network, the Internet, or a computer network (for example, a LAN or a wide area network (WAN)). The various kinds of communication modules may be integrated into a single component (for example, a single chip) or implemented with a plurality of components (for example, a plurality of chips).

A short-range wireless communication module may include, but is not limited to, a Bluetooth communication module, a BLE (Bluetooth Low Energy) communication module, a Near Field Communication module, a WLAN (Wi-Fi) communication module, a Zigbee communication module, an infrared (IrDA, infrared Data Association) communication module, a WFD (Wi-Fi Direct) communication module, an UWB (ultrawideband) communication module, an Ant+ communication module, a microwave (uWave) communication module, etc.

The long-distance wireless communication module may include a communication module that performs various kinds of long-distance communications, and may include a mobile communication device. The mobile communication device may transmit/receive a wireless signal to/from at least one of a base station, an external terminal, or a server on a mobile communication network.

According to an embodiment, the communication module may communicate with an external device, such as a server 3, a user device 2, another audio device, etc., through a surrounding Access Point (AP). The AP may connect a LAN to which the audio device 1 or the user device 2 is connected to a WAN to which the server is connected. The audio device 1 or the user device 2 may be connected to the server 3 through the WAN.

The communication device 30 may receive data from the server 30 and transfer the received data to the controller 50.

The microphone 40 may include a microphone. The microphone 40 may receive a surrounding sound. The microphone 40 may receive playback audio output from the speaker 50. The microphone 40 may convert the received playback audio into an electrical signal and transfer the electrical signal to the controller 50.

The speaker 60 may output the playback audio to outside. The controller 50 may reproduce an audio signal and output the audio signal to the outside through the speaker 60.

The controller 50 may be electrically connected to the user interface 20, the communication device 30, the microphone 40, and the speaker 60.

The controller 50 may include at least one memory 52 that stores data in a form of a program for controlling operations of components in the audio device 1, and at least one processor 51 that performs the above-described operations by using the data stored in the at least one memory 52. The memory 52 and processor 51 may be implemented as separate chips. Alternatively, the memory 52 and processor 51 may be implemented as a single chip.

The processor 51 may process an output signal from the user interface 20, the communication device 30, the microphone 40 and/or the speaker 60, and may include an operation circuit, a memory circuit and a control circuit that output control signals to the user interface 20, the communication device 30, the microphone 40, the speaker 60, etc., based on the processed result of the output signal.

The memory 52 may include volatile memory such as Static Random Access Memory (S-RAM) and Dynamic Random Access Memory (D-RAM), and nonvolatile memory such as Read Only Memory (ROM), Erasable Programmable Read Only Memory (EPROM), and flash memory.

The processor 51 may obtain a low frequency band ratio of a playback audio signal output through the speaker 60 and a low frequency band ratio of a microphone audio signal obtained through the microphone 40. The processor 51 may process the playback audio signal based on the low frequency band ratio of the playback audio signal and the low frequency band ratio of the microphone audio signal.

The processor 51 may correct the low frequency band of the playback audio signal such that the low frequency band ratio of the playback audio signal matches with the low frequency band ratio of the microphone audio signal.

Therefore, regardless of a space where the audio device 1 is installed, a low frequency band may be corrected quickly and simply and accordingly, a user may hear audio similar to original audio in the space.

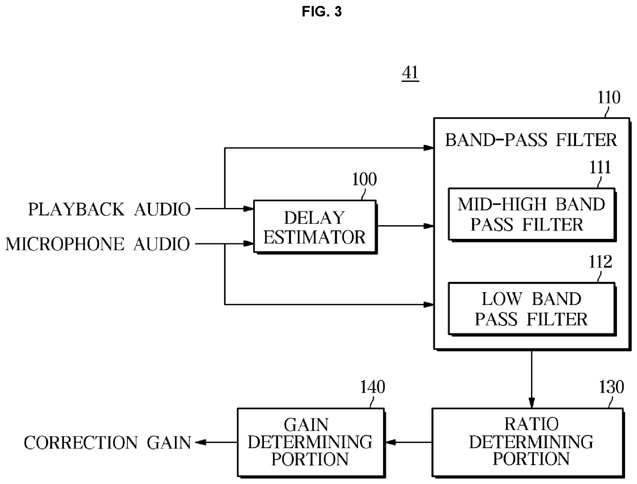

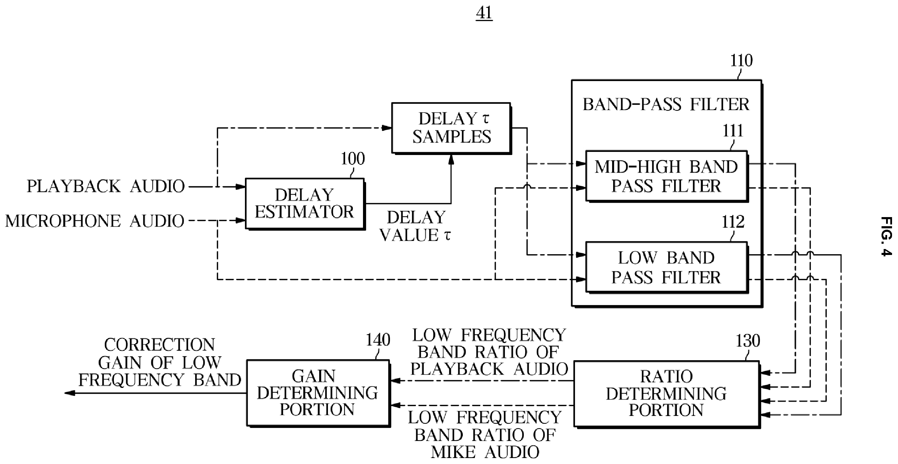

FIG. 3 shows a control block diagram of a processor of an audio device according to an embodiment of the present disclosure. FIG. 4 shows operations of a processor of an audio device according to an embodiment of the present disclosure.

Referring to FIGS. 3 and 4, the processor 51 may include a delay estimator 100, a band-pass filter 120, a ratio determining portion 130, and a gain determining portion 140.

The delay estimator 100 may estimate a delay between a playback audio signal and a microphone audio signal.

The delay estimator 100 may receive a playback audio signal and a microphone audio signal. The delay estimator 100 may receive a playback audio signal played through the speaker 60. The delay estimator 100 may receive a microphone audio signal received through the microphone 40.

The delay estimator 100 may estimate a delay value between the playback audio signal and the microphone audio signal by using correlation between the playback audio signal and the microphone audio signal. The estimated delay value may be applied to the playback audio signal to synchronize the playback audio signal with the microphone audio signal. Because the playback audio signal is output through the speaker 60 and the microphone audio signal is received through the microphone 40, a delay may occur between the two signals. The playback audio signal may be ahead of the microphone audio signal.

For example, a delay value between two signals may be estimated by determining similarity between the two signals based on cross-correlation. Cross-correlation may be a measure of how much similarity one signal has to another signal. By calculating cross-correlation, a delay value between two signals may be determined.

In a case where a delay value between the playback audio signal and the microphone audio signal is τ, the delay estimator 100 may synchronize the two signals by delaying the playback audio signal by τ samples, because the playback audio signal is ahead of the microphone audio signal.

The band-pass filter 120 may receive the synchronized playback audio signal and microphone audio signal. The band-pass filter 120 may receive the playback audio signal delayed by the delay estimator 100. The band-pass filter 110 may receive the microphone audio signal.

The band-pass filter 120 may filter only an audio signal of each frequency band from the received playback audio signal and microphone audio signal.

The band-pass filter 120 may include a mid-high band pass filter 111 and a low band pass filter 112.

The mid-high band pass filter 111 may be a filter that passes a first frequency band.

For example, the first frequency band may include a mid-high frequency band. The mid-high frequency band may be 500 Hz to 2500 Hz. Also, the mid-high frequency band may be 300 Hz to 1500 Hz.

The mid-high frequency band may be pre-set. The mid-high frequency band may be a band in which a frequency does not change significantly depending on a size of an installation space and reverberation conditions of the audio device 1, and the mid-high frequency band may be used as a reference band to express a relative size of a low frequency band that is greatly affected by an installation space.

The low band pass filter 112 may be a filter that passes a second frequency band.

For example, the second frequency band may be a frequency band that is lower than the first frequency band. The second frequency band may include a low frequency band. The low frequency band may be 1 Hz to 300 Hz. Also, the low frequency band may be 70 Hz to 160 Hz.

The mid-high band pass filter 111 may receive a playback audio signal and a microphone audio signal, and may pass only a mid-high frequency band from the received playback audio signal and microphone audio signal. For example, the mid-high band pass filter 111 may filter a mid-high frequency band of 300Hz to 1500Hz from the playback audio signal and the microphone audio signal.

The low band pass filter 112 may receive a playback audio signal and a microphone audio signal. The low band pass filter 112 may pass only a low frequency band from the received playback audio signal and microphone audio signal. For example, the low band pass filter 112 may filter only a low frequency band of 70 Hz to 160 Hz from the playback audio signal and the microphone audio signal.

The ratio determining portion 130 may receive signals output from the band-pass filter 120.

The ratio determining portion 130 may receive a playback audio signal and a microphone audio signal in a mid-high frequency band filtered by the mid-high band pass filter 111.

The ratio determining portion 130 may receive a playback audio signal and a microphone audio signal in a low frequency band filtered by the low band pass filter 112.

The ratio determining portion 130 may determine a root mean square (RMS) of the playback audio signal based on the filtered mid-high frequency band and low frequency band of the playback audio signal. An RMS may be one of measurement methods representing an amplitude of a signal. An RMS may be calculated by averaging squares of signals for a preset time and taking a square root of the average. The RMS may represent energy of the signals and may represent an intensity of audio.

The ratio determining portion 130 may determine an average RMS of the mid-high frequency band of the playback audio signal and an average RMS of the low frequency band of the playback audio signal

The ratio determining portion 130 may determine a low frequency band ratio of the playback audio signal based on the average RMS of the mid-high frequency band of the playback audio signal and the average RMS of the low frequency band of the playback audio signal. The ratio determining portion 130 may determine an RMS ratio of the low frequency band to the mid-high frequency band of the playback audio signal.

Also, the ratio determining portion 130 may determine an RMS for each frequency band of the microphone audio signal based on the filtered mid-high frequency band and low frequency band of the microphone audio signal.

The ratio determining portion 130 may determine an average RMS of the mid-high frequency band of the microphone audio signal and an average RMS of the low frequency band of the microphone audio signal.

The ratio determining portion 130 may determine a low frequency band ratio of the microphone audio signal based on the average RMS of the mid-high frequency band of the microphone audio signal and the average RMS of the low frequency band of the microphone audio signal. The ratio determining portion 130 may determine an RMS ratio of the low frequency band to the mid-high frequency band of the microphone audio signal.

The ratio determining portion 130 may output the low frequency band ratio of the playback audio signal and the low frequency band ratio value of the microphone audio signal to the gain determining portion 140. The low frequency band ratio of the playback audio signal and the low frequency band ratio of the microphone audio signal may be compared with each other and may be used as reference values to determine a correction gain for correcting a low frequency band of the actual audio device 1 which will be described below.

The gain determining portion 140 may receive the low frequency band ratio of the playback audio signal and the low frequency band ratio of the microphone audio signal from the ratio determining portion 130.

The gain determining portion 140 may determine a correction gain for adjusting the low frequency band ratio of the microphone audio signal based on the low frequency band ratio of the playback audio signal and the low frequency band ratio of the microphone audio signal.

The gain determining portion 140 may determine a correction gain for adjusting the low frequency band ratio of the microphone audio signal such that the low frequency band ratio of the microphone audio signal follows the low frequency band ratio of the playback audio signal.

According to the low frequency band ratio to the mid-high frequency band ratio of the microphone audio signal being higher than the low frequency band ratio to the mid-high frequency band ratio of the playback audio signal, the gain determining portion 140 may determine that a space where the audio device 1 is installed is a space where a booming phenomenon of a low frequency band occurs, and apply a minus gain value to the playback audio signal such that the low frequency band ratio is similar to a ratio of original audio. The booming phenomenon may be a phenomenon in which a low frequency band is amplified within a space where audio is played.

Meanwhile, according to the low frequency band ratio to the mid-high frequency band ratio of the microphone audio signal being lower than the low frequency band ratio to the mid-high frequency band ratio of the playback audio signal, the gain determining portion 140 may determine that the space where the audio device 1 is installed is a space where a low frequency band is more absorbed, and apply a plus gain value to the playback audio signal such that the low frequency band ratio is similar to the ratio of the original audio.

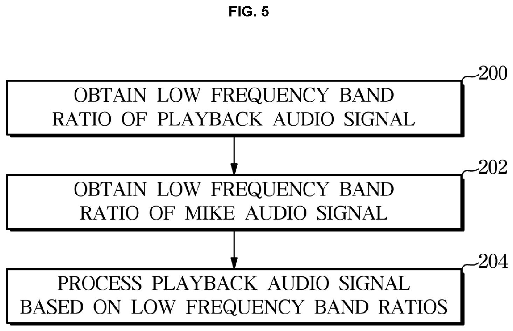

FIG. 5 shows an example of a flowchart illustrating a control method of an audio device according to an embodiment of the present disclosure.

Referring to FIG. 5, the processor 51 may obtain a low frequency band ratio of a playback audio signal output through the speaker 60 (200).

The processor 51 may estimate a delay value between the playback audio signal and a microphone audio signal and apply the delay value to the playback audio signal to synchronize the playback audio signal with the microphone audio signal.

The processor 51 may filter a mid-high frequency band and a low frequency band from the synchronized playback audio signal. For example, the mid-high frequency band may be 300 Hz to 1500 Hz. The mid-high frequency band may be preset and stored in the memory 52. The mid-high frequency band may be a band in which a frequency does not change significantly regardless of a size of an installation space and reverberation conditions of the audio device 1. The mid-high frequency band may be used as a reference band to express a relative size of a low frequency band which is greatly affected by the installation space. The low frequency band may be 70 Hz to 160 Hz.

The processor 51 may determine an average RMS of the mid-high frequency band of the playback audio signal and an average RMS of the low frequency band of the playback audio signal based on the filtered mid-high frequency band and low frequency band of the playback audio signal.

The processor 51 may determine an RMS ratio of the low frequency band to the mid-high frequency band of the playback audio signal based on the average RMS of the mid-high frequency band of the playback audio signal and the average RMS of the low frequency band of the playback audio signal.

Additionally, the processor 51 may obtain a low frequency band ratio of a microphone audio signal received through the microphone 40 (202).

The processor 51 may filter a mid-high frequency band and a low frequency band from the microphone audio signal. For example, the mid-high frequency band may be 300 Hz to 1500 Hz. The mid-high frequency band may be preset and stored in the memory 52. The low frequency band may be 70 Hz to 160 Hz.

The processor 51 may determine an average RMS of the mid-high frequency band of the microphone audio signal and an average RMS of the low frequency band of the microphone audio signal based on the filtered mid-high frequency band and low frequency band of the microphone audio signal.

The processor 51 may determine an RMS ratio of the low frequency band to the mid-high frequency band of the microphone audio signal based on the average RMS of the mid-high frequency band of the microphone audio signal and the average RMS of the low frequency band of the microphone audio signal.

The processor 51 may process the playback audio signal based on the low frequency band ratio of the playback audio signal and the low frequency band ratio of the microphone audio signal (204).

The processor 51 may determine a correction gain for adjusting the low frequency band ratio of the microphone audio signal based on the low frequency band ratio of the playback audio signal and the low frequency band ratio of the microphone audio signal. The processor 51 may determine a correction gain for adjusting the low frequency band ratio of the microphone audio signal such that the low frequency band ratio of the microphone audio signal follows the low frequency band ratio of the playback audio signal.

According to the low frequency band ratio to the mid-high frequency band ratio of the microphone audio signal being higher than the low frequency band ratio to the mid-high frequency band ratio of the playback audio signal, the processor 51 may reduce a correction gain value that is applied to the playback audio signal to prevent sound quality degradation due to a booming phenomenon of the low frequency band, thereby making the low frequency band ratio similar to a ratio of original audio.

According to the low frequency band ratio to the mid-high frequency band ratio of the microphone audio signal being lower than the low frequency band ratio to the mid-high frequency band ratio of the playback audio signal, the processor 51 may increase a correction gain value that is applied to the playback audio signal to prevent sound quality degradation due to absorption of the low frequency band, thereby making the low frequency band ratio similar to the ratio of the original audio.

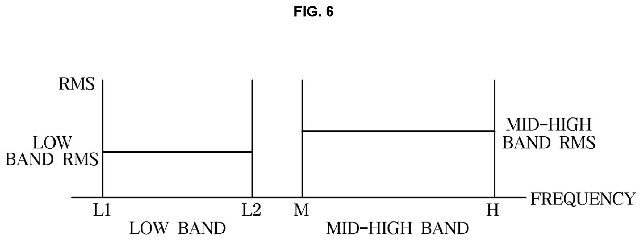

FIG. 6 shows examples of RMS values for frequency bands of a playback audio signal in an audio device according to an embodiment of the present disclosure.

Referring to FIG. 6, a horizontal axis may represent frequency and a vertical axis may represent RMS.

A low band RMS of a playback audio signal may include an average RMS of a low frequency band. The low frequency band may be L1 to L2 and may be 70 Hz to 160 Hz.

A mid-high band RMS of a playback audio signal may include an average RMS of a mid-high frequency band. The mid-high frequency band may be M to H and may be 300 Hz to 1500 Hz. The mid-high frequency band of the playback audio signal may be preset.

FIG. 6 shows a case in which a low band RMS of a playback audio signal is lower than a mid-high band RMS.

The processor 51 may determine a low frequency band ratio of a playback audio signal.

The low frequency band ratio of the playback audio signal may include an RMS ratio (low band RMS/mid-high band RMS) of a low frequency band to a mid-high frequency band of the playback audio signal.

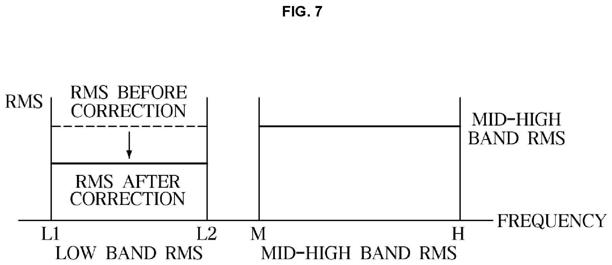

FIG. 7 shows examples of RMS values for frequency bands of a microphone audio signal in an audio device according to an embodiment of the present disclosure.

Referring to FIG. 7, a horizontal axis may represent frequency and a vertical axis may represent RMS.

A low band RMS of a microphone audio signal may include an average RMS of a low frequency band. The low frequency band may be L1 to L2 and may be 70Hz to 160Hz.

A mid-high band RMS of a microphone audio signal may include an average RMS of a mid-high frequency band. The mid-high frequency band may be M to H and may be 300 Hz to 1500 Hz. The mid-high frequency band of the microphone audio signal may be preset.

FIG. 7 shows a case where a low band RMS of a microphone audio signal before correction is equal to a mid-high band RMS.

The processor 51 may determine a low frequency band ratio of a microphone audio signal.

The low frequency band ratio of the microphone audio signal may include an RMS ratio (low band RMS/mid-high band RMS before correction) of a low frequency band to a mid-high frequency band of the microphone audio signal.

Referring to FIGS. 6 and 7, for example, a case where an RMS ratio (low band RMS/mid-high band RMS) of a low frequency band to a mid-high frequency band of a playback audio signal is 0.7 and an RMS ratio (low band RMS/mid-high band RMS before correction) of a low frequency band to a mid-high frequency band of a microphone audio signal is 1 may indicate that the low frequency band of the microphone audio signal has increased compared to an original audio signal. This may mean that a low frequency band of microphone audio has increased because a space where the audio device 1 is installed is a space where low frequency band booming occurs.

When the RMS of the microphone audio signal before correction is reduced to an RMS after correction, the low frequency band ratio of the playback audio signal may match with the low frequency band ratio of the microphone audio signal.

Therefore, by determining a correction gain for reducing the RMS before correction to the RMS after correction and applying the correction gain to the playback audio signal, the low frequency band ratio of the playback audio signal may match with the low frequency band ratio of the microphone audio signal.

Meanwhile, the low frequency band ratio of the playback audio signal may include a difference between mid-high frequency band dB (decibels) and low frequency band dB of the playback audio signal. The low frequency band ratio of the microphone audio signal may include a difference between mid-high frequency band dB (decibels) and low frequency band dB of the microphone audio signal.

Instead of comparing an RMS ratio (low band RMS/mid-high band RMS) of a low frequency band to a mid-high frequency band of a playback audio signal with an RMS ratio (low band RMS/mid-high band RMS) of a low frequency band to a mid-high frequency band of a microphone audio signal, an RMS of each frequency band may be converted to dB, a dB difference of a playback audio signal may be compared with a dB difference of a microphone audio signal, and the playback audio signal may be processed to match the dB difference of the microphone audio signal with the dB difference of the playback audio signal.

dB may express a relative strength of a signal by using a log scale. Converting an RMS to dB may be expressing a strength of a given signal in decibels.

As shown in Equation [1] below, an RMS may be converted to dB by using an exponential function.$dB = 20 ⋅ log 10 \left(RMS\right)$ Equation [1]

For example, a case where a value obtained by converting a mid-high band RMS of a playback audio signal to dB is 40 dB and a value obtained by converting a low band RMS to dB is 35dB is assumed. In this case, a dB difference based on the low band RMS may be -5 dB (35 dB - 40 dB).

Also, a case where a value obtained by converting a mid-high band RMS of a microphone audio signal to dB is 40 dB and a value obtained by converting a low band RMS to dB is 40 dB is assumed. In this case, a dB difference based on the low band RMS may be 0 dB (35 dB - 40 dB).

Because the dB has increased from -5 dB to 0 dB, it may be seen that the low frequency band has increased.

Therefore, a correction gain for reducing 0 dB to -5 dB may be determined, and by applying the correction gain to the playback audio signal, the low frequency band of the playback audio signal may be reduced.

In a case where the audio device 1 is installed in a corner very close to a back wall or side wall, when playback audio is generated into a space through the speaker 60, a booming phenomenon may occur in which a low frequency band resonates louder than original audio.

The audio device 1 according to an embodiment of the present disclosure may prevent low frequency band booming of audio played in a space regardless of an installation space of the audio device 1 by correcting a low frequency band ratio to match with a low frequency band ratio of an original sound even when the installation space of the audio device 1 changes. Therefore, a user may hear audio similar to the original audio in the space.

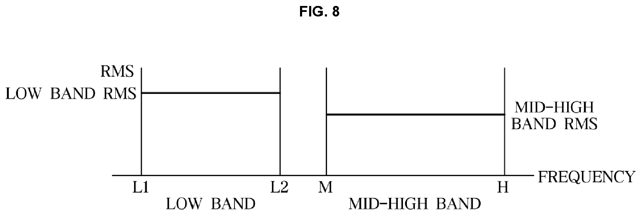

FIG. 8 shows other examples of RMS values for frequency bands of a playback audio signal in an audio device according to an embodiment of the present disclosure.

Referring to FIG. 8, a horizontal axis may represent frequency and a vertical axis may represent RMS.

A low band RMS of a playback audio signal may include an average RMS of a low frequency band. The low frequency band may be L1 to L2 and may be 70 Hz to 160 Hz.

A mid-high band RMS of the playback audio signal may include an average RMS of the mid-high frequency band. The mid-high frequency band may be M to H and may be 300 Hz to 1500 Hz. The mid-high frequency band of the playback audio signal may be preset.

FIG. 8 shows a case where a low band RMS of a playback audio signal is higher than a mid-high band RMS.

The processor 51 may determine a low frequency band ratio of a playback audio signal.

The low frequency band ratio of the playback audio signal may include an RMS ratio (low band RMS/mid-high band RMS) of a low frequency band to a mid-high frequency band of the playback audio signal.

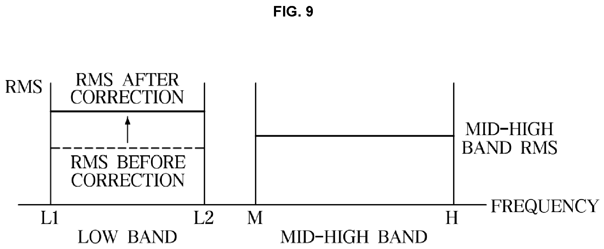

FIG. 9 shows other examples of RMS values for frequency bands of a microphone audio signal in an audio device according to an embodiment of the present disclosure.

Referring to FIG. 9, a horizontal axis may represent frequency, and a vertical axis may represent RMS.

A low band RMS of a microphone audio signal may include an average RMS of a low frequency band. The low frequency band may be L1 to L2 and may be 70 Hz to 160 Hz.

A mid-high band RMS of the microphone audio signal may include an average RMS of a mid-high frequency band. The mid-high frequency band may be M to H and may be 300 Hz to 1500 Hz. The mid-frequency band of the microphone audio signal may be preset.

FIG. 9 shows a case where a low band RMS of a microphone audio signal before correction is lower than a mid-high band RMS.

The processor 51 may determine a low frequency band ratio of the microphone audio signal.

The low frequency band ratio of the microphone audio signal may include an RMS ratio (low band RMS/mid-high band RMS before correction) of a low frequency band to a mid-high frequency band of the microphone audio signal.

Referring to FIGS. 8 and 9, for example, a case where an RMS ratio (low band RMS/mid-high band RMS) of a low frequency band to a mid-high frequency band of a playback audio signal is 1.2 and an RMS ratio (low band RMS/mid-high band RMS before correction) of a low frequency band to a mid-high frequency band of a microphone audio signal is 0.8 may indicate that the low frequency band of the microphone audio signal has decreased compared to an original audio signal. This may mean that a low frequency band of microphone audio has decreased because a space where the audio device 1 is installed is a space where low frequency band absorption occurs.

When an RMS of a microphone audio signal before correction is increased to an RMS after correction, a low frequency band ratio of a playback audio signal may match with a low frequency band ratio of a microphone audio signal.

Therefore, by determining a correction gain for increasing the RMS before correction to the RMS after correction and applying the correction gain to the playback audio signal, the low frequency band ratio of the playback audio signal may match with the low frequency band ratio of the microphone audio signal.

Meanwhile, the low frequency band ratio of the playback audio signal may include a difference between mid-high frequency band dB (decibels) and low frequency band dB of the playback audio signal. The low frequency band ratio of the microphone audio signal may include a difference between mid-high frequency band dB (decibels) and low frequency band dB of the microphone audio signal.

An RMS of each frequency band may be converted to dB, a dB difference of a playback audio signal may be compared with a dB difference of a microphone audio signal, and the playback audio signal may be processed to match the dB difference of the microphone audio signal with the dB difference of the playback audio signal.

For example, a case where a value obtained by converting a mid-high band RMS of a playback audio signal to dB is 40 dB and a value obtained by converting a low band RMS to dB is 45 dB is assumed. In this case, a dB difference based on the low band RMS may be 5 dB (45 dB - 40 dB).

Also, a case where a value obtained by converting a mid-high band RMS of a microphone audio signal to dB is 40 dB and a value obtained by converting a low band RMS to dB is 35 dB is assumed. In this case, a dB difference based on the low band RMS may be -5 dB (35 dB - 40 dB).

Because the dB has decreased from 5 dB to -5 dB, it may be seen that a low frequency band has increased.

Therefore, by determining a correction gain for increasing -5 dB to 5 dB and applying the correction gain to the playback audio signal, the low frequency band of the playback audio signal may be increased.

In a case where the audio device 1 is installed in a center of a space, when playback audio is generated into the space through the speaker 60, audio played in the space may not have a sufficient low frequency band compared to a low frequency band of original audio, due to low frequency band absorption.

The audio device 1 according to an embodiment of the present disclosure may correct a low frequency band ratio to match with a low frequency band ratio of original sound even when an installation space of the audio device 1 changes, thereby enabling a user to experience audio similar to a low band of original audio regardless of the installation space of the audio device 1.

As described above, a low frequency band may be corrected quickly and simply even when the audio device 1 is freely installed according to an individual's spatial environment, and accordingly, a user may experience audio quality similar to original audio in a space.

Meanwhile, the audio device 1 according to an embodiment of the present disclosure may be applied not only to a time domain but also to a frequency domain.

In this case, the processor 51 may include a Fourier Transform (FFT) processor that converts a time domain to a frequency domain, instead of the band-pass filter 120. The ratio determining portion 130 may determine a FFT size of a mid-high frequency band and a FFT size of a low frequency band, and determine a low frequency band ratio based on each size.

An electronic device according to an embodiment of the present disclosure may include: a speaker; a microphone; and a processor configured to obtain a low frequency band ratio of a playback audio signal output through the speaker and a low frequency band ratio of a microphone audio signal received through the microphone, and process the playback audio signal based on the low frequency band ratio of the playback audio signal and the low frequency band ratio of the microphone audio signal.

The processor may be configured to estimate a delay value based on a correlation between the playback audio signal and the microphone audio signal and apply the delay value to the playback audio signal to synchronize the playback audio signal with the microphone audio signal.

The processor may be configured to filter mid-high frequency bands and low frequency bands from the playback audio signal and the microphone audio signal.

The processor may be configured to determine the playback audio signal and an average RMS for each frequency band based on the filtered mid-high frequency band and the filtered low frequency band of the playback audio signal, and determine a ratio of the low frequency band to the mid-high frequency band of the playback audio signal based on an average RMS of the mid-high frequency band and an average RMS of the low frequency band.

The processor may be configured to determine the playback audio signal and an average RMS for each frequency band based on the filtered mid-high frequency band and the filtered low frequency band of the playback audio signal, determine a dB difference between the mid-high frequency band and the low frequency band based on an average RMS of the mid-high frequency band and an average RMS of the low frequency band, and determine the low frequency band ratio of the playback audio signal based on the dB difference.

The processor may be configured to determine the microphone audio signal and an average RMS for each frequency band based on the filtered mid-high frequency band and the filtered low-frequency band of the microphone audio signal, and determine a ratio of the low frequency band to the mid-high frequency band of the microphone audio signal based on the average RMS of the mid-high frequency band and the average RMS of the low frequency band.

The processor may be configured to determine the microphone audio signal and an average RMS for each frequency band based on the filtered mid-high frequency band and the filtered low frequency band of the microphone audio signal, determine a dB difference between the mid-high frequency band and the low frequency band based on an average RMS of the mid-high frequency band and an average RMS of the low frequency band, and determine the low frequency band ratio of the microphone audio signal based on the dB difference.

The processor may be configured to determine a correction gain for adjusting the low frequency band ratio of the microphone audio signal based on the low frequency band ratio of the playback audio signal and the low frequency band ratio of the microphone audio signal.

The processor may be configured to determine the correction gain such that the low frequency band ratio of the microphone audio signal follows the low frequency band ratio of the playback audio signal.

The processor may be configured to process the playback audio signal by applying the correction gain to the playback audio signal output through the speaker.

The processor may be configured to, based on the low frequency band ratio of the microphone audio signal being higher than the low frequency band ratio of the playback audio signal, apply a plus correction gain to the playback audio signal.

The processor may be configured to, based on the low frequency band ratio of the microphone audio signal being lower than the low frequency band ratio of the playback audio signal, apply a plus correction gain to the playback audio signal.

A control method of an electronic device according to an embodiment of the present disclosure may include: obtaining a low frequency band ratio of a playback audio signal output through a speaker; obtaining a low frequency band ratio of a microphone audio signal received through a microphone; and processing the playback audio signal based on the low frequency band ratio of the playback audio signal and the low frequency band ratio of the microphone audio signal.

The obtaining of the low frequency band ratio of the playback audio signal may include filtering a mid-high frequency band and a low frequency band from the playback audio signal, determining the playback audio signal and an average RMS for each frequency band based on the filtered mid-high frequency band and the filtered low frequency band of the playback audio signal, and determining a ratio of the low frequency band to the mid-high frequency band of the playback audio signal based on an average RMS of the mid-high frequency band and an average RMS of the low frequency band.

The obtaining of the low frequency band ratio of the playback audio signal may include filtering a mid-high frequency band and a low frequency band from the playback audio signal, determining the playback audio signal and an average RMS for each frequency band based on the filtered mid-high frequency band and the filtered low frequency band of the playback audio signal, determining a dB difference between the mid-high frequency band and the low frequency band based on an average RMS of the mid-high frequency band and an average RMS of the low frequency band, and determining the low frequency band ratio of the playback audio signal based on the dB difference.

The obtaining of the low frequency band ratio of the microphone audio signal may include filtering a mid-high frequency band and a low frequency band from the microphone audio signal, determining the microphone audio signal and an average RMS for each frequency band based on the filtered mid-high frequency band and the filtered low frequency band of the microphone audio signal, and determining a ratio of the low frequency band to the mid-high frequency band of the microphone audio signal based on an average RMS of the mid-high frequency band and an average RMS of the low frequency band.

The obtaining of the low frequency band ratio of the microphone audio signal may include filtering a mid-high frequency band and a low frequency band from the microphone audio signal, determining the microphone audio signal and an average RMS for each frequency band based on the filtered mid-high frequency band and the filtered low frequency band of the microphone audio signal, and determining a dB difference between the mid-high frequency band and the low frequency band based on an average RMS of the mid-high frequency band and an average RMS of the low frequency band, and determining the low frequency band ratio of the microphone audio signal based on the dB difference.

The processing of the playback audio signal may include determining a correction gain based on the low frequency band ratio of the playback audio signal and the low frequency band ratio of the microphone audio signal such that the low frequency band ratio of the microphone audio signal follows the low frequency band ratio of the playback audio signal, and applying the correction gain to the playback audio signal output through the speaker.

The processing of the playback audio signal may include, based on the low frequency band ratio of the microphone audio signal being higher than the low frequency band ratio of the playback audio signal, applying a minus correction gain to the playback audio signal, and the processing of the playback audio signal may include, based on the low frequency band ratio of the microphone audio signal being lower than the low frequency band ratio of the playback audio signal, applying a minus correction gain to the playback audio signal.

A non-transitory storage medium according to an embodiment of the present disclosure, storing instructions readable by a computer, may cause, when the instructions are executed by a processor, the processor to obtain a low frequency band ratio of a playback audio signal output through a speaker; obtain a low frequency band ratio of a microphone audio signal received through a microphone; and process the playback audio signal based on the low frequency band ratio of the playback audio signal and the low frequency band ratio of the microphone audio signal.

Meanwhile, the disclosed embodiments may be implemented in the form of a storage medium that stores instructions executable by a computer. The instructions may be stored in the form of program codes, and when executed by a processor, the instructions may create a program module to perform operations of the disclosed embodiments.

A machine-readable storage medium may be provided in the form of a non-transitory storage medium, wherein the term 'non-transitory storage medium' simply means that the storage medium is a tangible device, and does not include a signal (e.g., an electromagnetic wave), but this term does not differentiate between where data is semi-permanently stored in the storage medium and where the data is temporarily stored in the storage medium. For example, the 'non-transitory storage medium' may include a buffer in which data is temporarily stored.

According to an embodiment, a method according to various embodiments disclosed in this document may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloadable or uploadable) online via an application store (e.g., Play Store^{™}) or between two user devices (e.g., smart phones) directly. When distributed online, at least part of the computer program product (e.g., a downloadable app) may be temporarily generated or at least temporarily stored in the machine-readable storage medium, such as a memory of the manufacturer's server, a server of the application store, or a relay server.

So far, the disclosed embodiments have been described with reference to the accompanying drawings. It will be understood by one of ordinary skill in the technical art to which the present disclosure belongs that the disclosure can be embodied in different forms from the disclosed embodiments without changing the technical spirit and essential features of the present disclosure. Thus, it should be understood that the disclosed embodiments are merely for illustrative purposes and not for limitation purposes.

## Claims

1. An electronic device comprising:
a speaker;
a microphone; and
a processor configured to obtain a low frequency band ratio of a playback audio signal output through the speaker and a low frequency band ratio of a microphone audio signal received through the microphone, and process the playback audio signal based on the low frequency band ratio of the playback audio signal and the low frequency band ratio of the microphone audio signal.

2. The electronic device of claim 1, wherein
the processor is configured to estimate a delay value based on a correlation between the playback audio signal and the microphone audio signal and apply the delay value to the playback audio signal to synchronize the playback audio signal with the microphone audio signal.

3. The electronic device of claim 1, wherein
the processor is configured to filter mid-high frequency bands and low frequency bands from the playback audio signal and the microphone audio signal.

4. The electronic device of claim 3, wherein
the processor is configured to determine the playback audio signal and an average root mean square (RMS) for each frequency band based on the filtered mid-high frequency band and the filtered low frequency band of the playback audio signal, and determine a ratio of the low frequency band to the mid-high frequency band of the playback audio signal based on an average RMS of the mid-high frequency band and an average RMS of the low frequency band.

5. The electronic device of claim 3, wherein
the processor is configured to determine the playback audio signal and an average root mean square (RMS) for each frequency band based on the filtered mid-high frequency band and the filtered low frequency band of the playback audio signal, determine a dB difference between the mid-high frequency band and the low frequency band based on an average RMS of the mid-high frequency band and an average RMS of the low frequency band, and determine the low frequency band ratio of the playback audio signal based on the dB difference.

6. The electronic device of claim 3, wherein
the processor is configured to determine the microphone audio signal and an average root mean square (RMS) for each frequency band based on the filtered mid-high frequency band and the filtered low-frequency band of the microphone audio signal, and determine a ratio of the low frequency band to the mid-high frequency band of the microphone audio signal based on the average RMS of the mid-high frequency band and the average RMS of the low frequency band.

7. The electronic device of claim 3, wherein
the processor is configured to determine the microphone audio signal and an average root mean square (RMS) for each frequency band based on the filtered mid-high frequency band and the filtered low frequency band of the microphone audio signal, determine a dB difference between the mid-high frequency band and the low frequency band based on an average RMS of the mid-high frequency band and an average RMS of the low frequency band, and determine the low frequency band ratio of the microphone audio signal based on the dB difference.

8. The electronic device of claim 1, wherein
the processor is configured to determine a correction gain for adjusting the low frequency band ratio of the microphone audio signal based on the low frequency band ratio of the playback audio signal and the low frequency band ratio of the microphone audio signal.

9. The electronic device of claim 8, wherein
the processor is configured to determine the correction gain such that the low frequency band ratio of the microphone audio signal follows the low frequency band ratio of the playback audio signal.

10. The electronic device of claim 8, wherein
the processor is configured to process the playback audio signal by applying the correction gain to the playback audio signal output through the speaker.

11. The electronic device of claim 8, wherein
the processor is configured to, based on the low frequency band ratio of the microphone audio signal being higher than the low frequency band ratio of the playback audio signal, apply a minus correction gain to the playback audio signal.

12. The electronic device of claim 8, wherein
the processor is configured to, based on the low frequency band ratio of the microphone audio signal being lower than the low frequency band ratio of the playback audio signal, apply a plus correction gain to the playback audio signal.

13. A control method of an electronic device, comprising:
obtaining a low frequency band ratio of a playback audio signal output through a speaker;
obtaining a low frequency band ratio of a microphone audio signal received through a microphone; and
processing the playback audio signal based on the low frequency band ratio of the playback audio signal and the low frequency band ratio of the microphone audio signal.

14. The control method of claim 13, wherein
the obtaining of the low frequency band ratio of the playback audio signal comprises
filtering a mid-high frequency band and a low frequency band from the playback audio signal,
determining the playback audio signal and an average root mean square (RMS) for each frequency band based on the filtered mid-high frequency band and the filtered low frequency band of the playback audio signal, and
determining a ratio of the low frequency band to the mid-high frequency band of the playback audio signal based on an average RMS of the mid-high frequency band and an average RMS of the low frequency band.

15. The control method of claim 13, wherein
the obtaining of the low frequency band ratio of the playback audio signal comprises
filtering a mid-high frequency band and a low frequency band from the playback audio signal,
determining the playback audio signal and an average root mean square (RMS) for each frequency band based on the filtered mid-high frequency band and the filtered low frequency band of the playback audio signal,
determining a dB difference between the mid-high frequency band and the low frequency band based on an average RMS of the mid-high frequency band and an average RMS of the low frequency band, and
determining the low frequency band ratio of the playback audio signal based on the dB difference.
